# DEMANDE DE BREVET EUROPEEN

(11) **EP 3 107 358 A1**
(43) Date de publication de la demande: **21.12.2016**
(21) Numéro de dépôt: 16174867.8
(22) Date de dépôt: 16.06.2016
(51) Int. Cl.: H05K 1/02

(54) **COMPOSANT DE PROTECTION DE SIGNAUX SENSIBLES, DISPOSITIF ET PROCÉDÉ CORRESPONDANT**

(30) Priorité: 16.06.2015 FR 1555513
(71) Demandeur: Ingenico Group, 75015 Paris (FR)
(72) Inventeur: ROSSIGNOL, Michel, 26760 MONTLEGER (FR); BERTHIAUD, Olivier, 07130 CORNAS (FR)
(74) Mandataire: Vidon Brevets & Stratégie

(57) **Abrégé**

L'invention se rapporte à un composant électronique (300). Un tel composant électronique comprend.
- une enveloppe (310) formant boitier;
- une plaque de circuit imprimé (320) ;
- une pluralité de billes intégrées au sein d'une matrice de bille (BGA) ;
il se distingue par le fait ladite plaque de circuit imprimé (320) comprend au moins un circuit définissant au moins un anneau de garde (Ag, A1, A2).

## Description

### 1. Domaine de l'invention

L'invention se rapporte au domaine de la protection des signaux sensibles sur circuit imprimé. Plus particulièrement, l'invention se rapporte à la protection des signaux sensibles à certain emplacements d'un circuit imprimé. L'invention trouve une application dans tous les circuits imprimés véhiculant des données qui peuvent faire l'objet d'une tentative d'attaque ou de vol de la part d'un individu mal intentionné. La technique décrite trouve par exemple à s'appliquer au sein des terminaux de paiement, dans lesquels de nombreux signaux sensibles sont transmis.

### 2. Art Antérieur

La sécurité des données électroniques est devenu un facteur indispensable lors de la conception des dispositifs qui contiennent ou traitent des informations confidentielles. Ceci est par exemple le cas dans des terminaux spécifiques, comme des terminaux de paiement, certains circuits spécifiques d'ordinateurs portables ou de smartphones, des dispositifs de saisie (« *pinpad* ») ou des dispositifs biométriques (lecteurs d'empreintes digitales).

Par exemple, les terminaux de paiement permettant de traiter les transactions bancaires doivent être certifiés selon des normes dites PCI (de l'anglais pour *« paiement card industry* »). Ces normes assurent que le terminal est résistant à un certain nombre de scénarii d'attaque. Certains de ces scénarii d'attaque ont justement pour objectif d'accéder à certains signaux sensibles qui transitent au sein du terminal de paiement. De tels signaux peuvent par exemple être les signaux qui transitent entre une carte bancaire et le terminal de paiement. Il peut également s'agir des signaux qui sont représentatifs des touches qui sont actionnées sur un clavier. Dans les terminaux de paiement, comme dans les autres dispositifs électroniques, les informations sont représentées par les signaux transmis à des composants électroniques par les pistes conductrices du circuit imprimé (également appelé PCB, de l'anglais *« printed circuit board* »). Avec les années et l'amélioration continue des techniques de fabrication, les cartes de circuits imprimés (sur lesquelles les composants électroniques sont montés) sont souvent multicouches. Cela signifie que les signaux sont transmis dans de multiples couches du circuit imprimé. En effet, plutôt que de multiplier la surface d'un circuit imprimé, il est plus judicieux de multiplier les couches de celui-ci, permettant ainsi d'obtenir une surface équivalente à plusieurs fois la surface réelle du circuit imprimé, tout en limitant la taille de celui-ci. Pour faire transiter les signaux d'une couche à l'autre, on utilise souvent la technique dite de la via : une « via » est un trou dans lequel un fil de cuivre est inséré. Ce trou permet à un signal de passer d'une couche à l'autre. Il existe des via qui permette de relier uniquement deux couche superposées l'une sur l'autre ou des vias qui permettent de relier plusieurs couches voire toutes les couches du circuit imprimé.

Ainsi, les signaux sensibles transitent eux aussi par l'intermédiaire de vias disposés sur le PCB. Pour protéger les signaux sensibles, il est donc nécessaire non seulement de protéger les pistes conductrices, mais également de protéger les vias sur le PCB. En effet, il est relativement fréquent que les scénarii d'attaques, définis par l'industrie, prévoient une phase d'attaque des signaux transitant dans les vias.

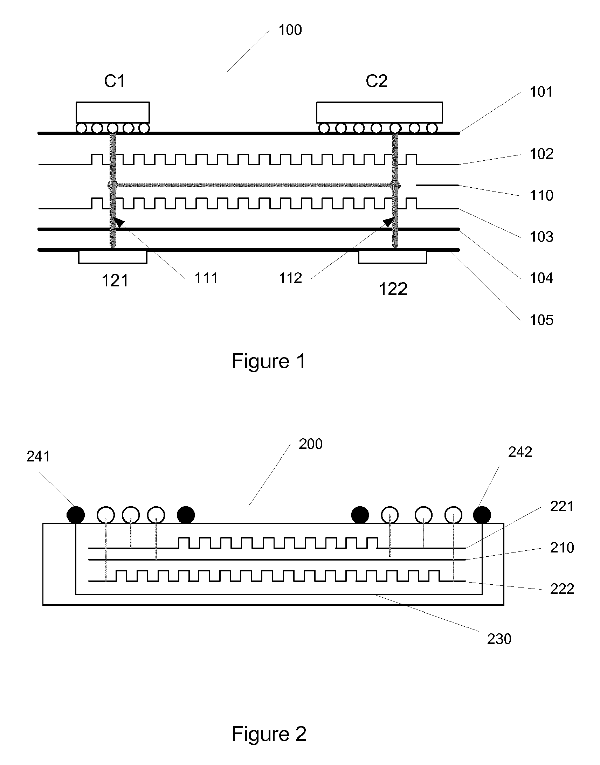

Une solution traditionnelle de protection des signaux sensibles des vias est illustrée, à titre d'information, dans la figure 1. Cette solution consiste à développer un PCB multicouches, de fable taille appelé « cache via ». Le ou les caches vias sont soudés au PCB principal, par-dessus celui-ci, et sont placés au-dessus de l'endroit où se situent les via. Dans l'exemple de la figure 1, un PCB 100 comprend six couches : une première couche 101, dite couche supérieure, comprenant un circuit de piste conductrice et des composants électroniques ; une couche de protection 102, prenant la forme d'un treillis ; une couche de transmission d'un signal sensible 110 ; une deuxième couche de protection 103, prenant la forme d'un treillis et permettant de former une barrière avec la première couche de protection 102 ; une couche de circuit imprimé classique 104, qui nécessite la présence du signal sensible ; et enfin une couche inférieure 105. Dans cet exemple, deux vias 111 et 112 sont représentées. Elles permettent de faire transiter le signal sensible entre les couches. La couche 110 de routage des signaux sensibles se situe au milieu des deux couches de protections (treillis 1 et treillis 2). Ainsi, les pistes sur la couche de routage des signaux sensibles sont protégés par les deux couche de protections (treillis 1 et treillis 2). Le PCB multicouche comprend aussi des caches via 121, 122 (cache via 1 et cache via 2) situées au-dessus des vias 111, 112 disposés sur le PCB.

Les caches via 121, 122 sont réalisées traditionnellement avec un PCB spécifique. Dans l'exemple illustré dans la figure 2, le cache via est réalisé à l'aide d'un circuit imprimé de quatre couches comprenant deux couches de treillis 221, 222, une couche de routage de signal sensible 210 et une couche de routage de la masse 240. La couche de routage de signal sensible 210 se trouve au milieu des deux couches de treillis 221, 222 : pour plus de sécurité, le signal sensible de la via est routé dans ce PCB spécifique. Deux matrices de billes (en anglais « Ball Grid Array » ou BGA) 241, 242 sont disposées sur la cache via et permet au celui-ci d'être soudée sur un PCB.

Un cas courant de réalisation consiste également à ne pas router le signal sensible de la via dans ce PCB spécifique. Ce cas d'utilisation courant peut être sous optimal, dans certaines conditions, mais il est moins cher à produire.

Ainsi, un circuit imprimé spécifique (le cache via) est soudé sur le circuit électronique principal. Lorsqu'un attaquant souhaite accéder à la via, il doit alors trouver un moyen de passer outre la protection offerte par le cache via, ce qui s'avère généralement complexe ou long. La protection offerte, en tant que telle est donc relativement satisfaisante.

Cependant, Ces caches via de l'art antérieur sont spécifiquement conçus et fabriqués pour remplir la fonction de protection contre l'accès aux signaux sensibles par les vias disposés sur le PCB. Cela nécessite de fabriquer des pièces spécifiques pour la fabrication du dispositif électronique. Du point de vue de la gestion de la chaîne logistique, il est coûteux de maintenir un grand nombre de composants (« BOM - en anglais Bill of Materials ») pour la fabrication d'un produit. Il est toujours souhaitable de réduire le nombre des composants dans la liste des pièces nécessaires afin de réduire le coût logistique pour la fabrication. Par ailleurs, les contremesures de sécurité au sein des caches via de l'antérieur sont d'une part compliquées et d'autre part coûteuses à mettre en oeuvre : en effet, construire un PCB multicouches est couteux et devoir construire un tel PCB multicouches uniquement pour des besoins de protection est insatisfaisant. Par ailleurs, le PCB multicouches a un autre inconvénient : il permet de renseigner l'attaquant sur l'endroit où se situent les vias comprenant les signaux sensibles. En effet, il suffit, pour l'attaquant, d'observer le PCB principal pour détecter immédiatement l'emplacement des vias : elles se situent sous les PCB de protection multicouches. Dès lors, bien qu'apportant une protection relativement efficace, le PCB de protection multicouches, apporte à l'attaquant une information qu'il ne possède pas, ce qui est, à tout le moins, sous optimal en termes de protection effective.

### 3. Résumé

La présente divulgation permet de résoudre les problèmes posés dans l'art antérieur. En effet, la présente divulgation se rapporte à une méthode de protection d'un signal sensible, ledit signal sensible étant susceptible de transiter par l'intermédiaire d'une via d'un circuit électronique comprenant au moins deux couches.

La technique de protection est mise en oeuvre par un composant électronique comprenant :
- une enveloppe formant boitier;
- une plaque de circuit imprimé ;
- une pluralité de billes intégrées au sein d'une matrice de bille.

Selon la présente divulgation, ladite plaque de circuit imprimé comprend au moins un circuit définissant au moins un anneau de garde.

Ainsi, il est possible, grâce à ce composant, d'empêcher le perçage d'un circuit imprimé sur lequel le composant est fixé, tout en disposant d'une protection latérale contre l'intrusion à l'aide d'un anneau de garde.

Selon une caractéristique particulière, ladite plaque de circuit imprimé comprend en outre au moins un circuit de liaison entre une première connexion et une deuxième connexion de ladite plaque de circuit imprimé.

Ainsi, le composant dispose d'un circuit de liaison, interne, permettant de résister aux tentatives d'intrusion et/ ou de détecter ces tentatives.

Selon une caractéristique particulière, le circuit de liaison comprend au moins une résistance d'une valeur prédéterminée. Ainsi, toute tentative d'imiter le fonctionnement du composant nécessite de disposer de cette valeur, qui est propre au composant et donc complexe à obtenir sans disposer d'une copie du composant lui-même.

Selon un autre aspect, la technique proposée se rapporte également à un procédé de protection d'un signal électrique transitant par l'intermédiaire d'une via d'un circuit imprimé multicouches, ladite via reliant au moins deux couches dudit circuit imprimé multicouches. Un tel procédé met en oeuvre un composant électronique tel que défini précédemment.

Selon un autre aspect, complémentaire, la technique proposée se rapporte également à l'utilisation d'un composant électronique tel que défini précédemment pour protéger un signal transitant entre au moins deux couches d'un circuit imprimé d'un dispositif électronique.

Selon un autre aspect, la technique proposée se rapporte également à un dispositif électronique de saisie de données. Un tel dispositif un composant électronique tel que défini précédemment, fixé sur un circuit imprimé pour protéger un signal transitant entre au moins deux couches dudit circuit imprimé.

Un tel agencement présente l'avantage de ne pas permettre à une personne mal intentionnée de disposer de données sur l'emplacement du signal sensible qui est protégé. En effet, de par la présence d'une enveloppe externe formant boitier, le composant ne se distingue pas d'un composant similaire qui remplirait une fonction différente. Il est dès lors complexe, pour la personne mal intentionnée, de repérer le composant de protection par rapport à un autre composant.

### 4. Figures

D'autres caractéristiques et avantages apparaîtront plus clairement à la lecture de la description suivante d'un mode de réalisation particulier de la divulgation, donné à titre de simple exemple illustratif et non limitatif, et des dessins annexés, parmi lesquels :
- la figure 1, déjà présentée, est une vue en coupe d'un PCB protégeant les signaux sensible de l'art antérieur ;
- la figure 2, déjà présentée, illustre un cache via de l'art antérieur réalisé à l'aide d'un PCB multicouches ;
- la figure 3a est une vue de dessous du composant flip chip BGA mis en oeuvre selon un mode de réalisation de l'invention ;
- la figure 3b est un vu en coupe d'un composant flip chip BGA mis en oeuvre selon l'invention pour protéger une via ;
- la figure 4 est une vue de dessous illustrant la manière dont les billes du composant flip chip BGA sont soudées pour obtenir l'effet de protection recherché;
- la figure 5 est une vue de coupe d'un circuit PCB équipé d'un composant flip chip BGA (cache via flip chip) selon l'invention ;
- la figure 6 illustre un circuit intégré, défini selon la présente technique et comprenant deux anneau de garde.

### 5. Description détaillée

L'objet de la présente technique est de supprimer le besoin d'un PCB multicouche spécifique pour mettre en oeuvre la fonction de cache via et de le remplacer ce PCB multicouche spécifique par un composant « traditionnel », afin de réduire les coûts de fabrication et d'optimiser le processus de soudage sur le cuivre.

Le principe général de la technique décrite consiste à utiliser un composant BGA en technologie flip chip dans une utilisation particulière. Comme son nom l'indique une puce flip chip est retournée dans le boitier BGA, le montage du cache via réalisé par flip chip BGA est plus simple. Les flip-chips en BGA sont les composants courants et de moindre prix. L'utilisation de ces composants pour réaliser les cache via permet de réduire le coût logistique et le coût d'achat pour la fabrication des dispositifs électroniques. De manière complémentaire, l'attaquant n'est dès lors pas en mesure de détecter la via par une simple observation du PCB : en effet rien ne permettra de différentier un composant flip chip d'un autre ; l'attaquant ne peut donc pas, à l'oeil nu, faire la différence entre les différentes utilisations du flip chip.

La technique est plus particulièrement mise en oeuvre par l'intermédiaire d'un composant électronique comprenant une enveloppe formant boitier; une plaque de circuit imprimé ; et une pluralité de billes intégrées au sein d'une matrice de bille; la plaque de circuit imprimé comprend au moins un circuit définissant au moins un anneau de garde. Selon le mode de réalisation, le composant comprend également un circuit de liaison qui permet de relier le composant à un treillis de protection présent sur le PCB sur lequel le composant est soudé. Ceci permet de se prémunir contre des tentatives de violation de l'intégrité du composant en détectant celle-ci par une ouverture du circuit défini par le treillis.

Un autre avantage de la solution réside dans le fait d'utiliser des boitiers BGA classiques sans avoir à développer un composant spécifique. Ils sont donc utilisables dans un processus industriel de montage de composants comme n'importe quel autre composant.

Un autre objet de l'invention consiste d'améliorer les contremesures de sécurité tout en assurant une mise en oeuvre simplifiée et un coût réduit. Pour ce faire, l'invention consiste à faire transiter des signaux sécurisés à l'intérieur du cache via réalisé par flip chip BGA. Les signaux qui transitent dans le cache via flip chip BGA permettent de protéger les signaux sensilles et le cache via lui-même. Selon un mode de réalisation de l'invention, au moins deux pins (billes du BGA) du cache via flip chip BGA sont reliés entre elles avec une résistance série donnée (définie sur le circuit imprimé composant). Ainsi les vias placées sous le boitier Flip Chip sont protégés contre les attaques par dessoudage ou perçages.

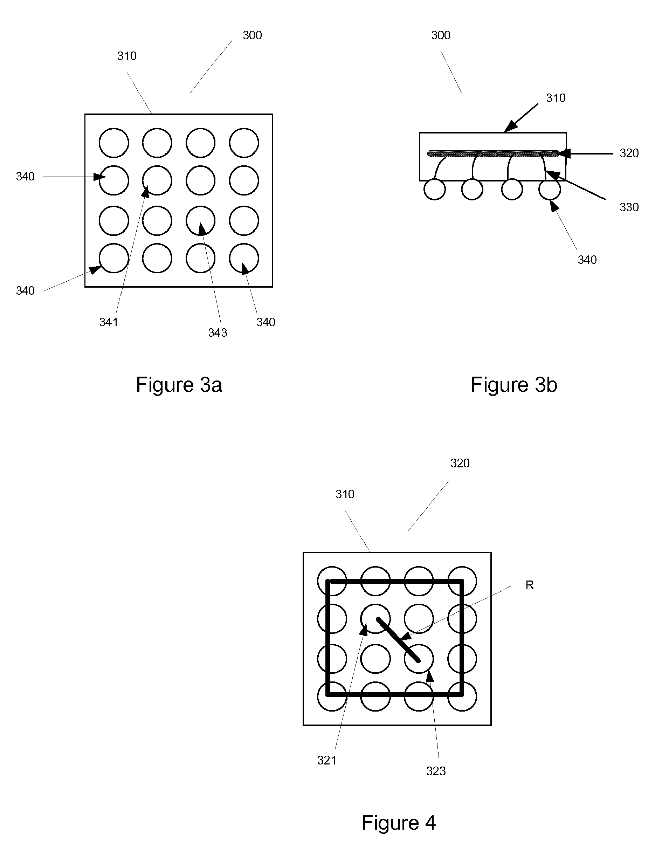

Les figures 3a et 3b sont respectivement une vue par dessous et une vue en coupe du composant flip chip BGA selon un mode de réalisation de configuration en accord avec la présente technique. Le composant flip chip BGA 300 comprend, dans cet exemple, un boîtier 310 de préférence en plastique, une matrice (par exemple 4x4) 340 de billes de soudure et des bondings 330 reliant les billes de soudure 340 avec la puce flip chip 320.

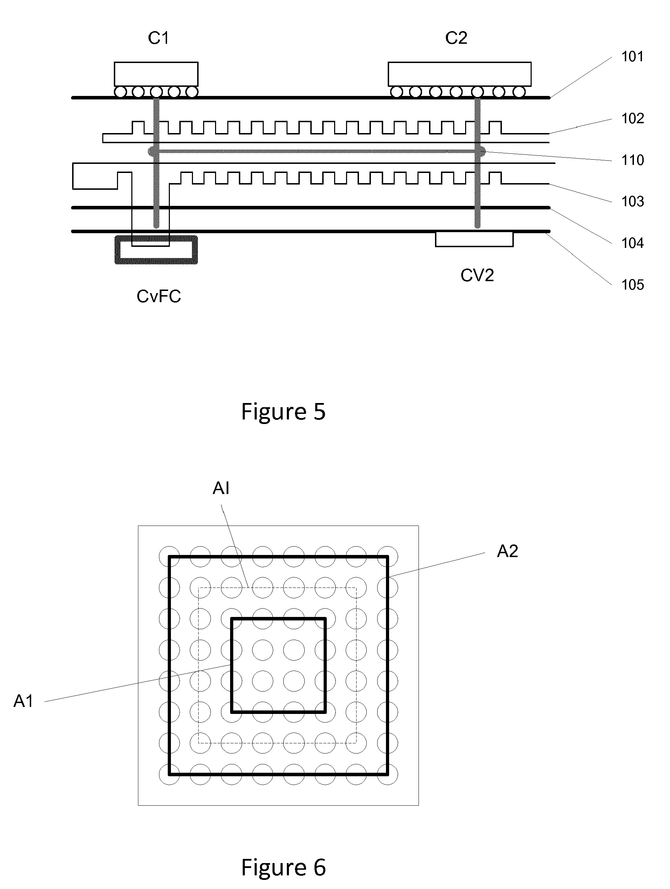

La figure 4 illustre une surface du flip chip 320 opposée à la matrice de billes 310. Sur cette surface du flip chip 230, on dispose une matrice de points de soudage correspondant à la matrice de billes (BGA). Les points de soudage périphériques sont reliés entre eux et forme une barrière de protection connectée à la masse : cette « barrière » permet d'assurer une détection d'une tentative de perçage latéral du composant, lorsque celui-ci est soudé sur le boitier. Deux connexions ou points de soudage (par exemple 321 et 323) sont reliés par l'intermédiaire d'une résistance R ayant une valeur de résistance prédéterminée. Ces deux points de soudage sont respectivement connectés aux billes 341 et 343. Lors du montage du composant flip chip BGA sur un PCB, les billes périphériques (340) sont soudées sur le PCB et connectées à la masse. Les billes 341 et 343 sont connectées en série avec un treillis du PCB (c.f. figure5). Ainsi, par exemple, si un attaquant insère une sonde dans le composant, un détecteur (par exemple un détecteur capacitif [non illustré]) peut détecter une variation entre la masse et le treillis. Cette attaque par sonde est par conséquence détectée. Lorsqu'un attaquant tente de démonter le cache via et dessoude les billes du composant flip chip BGA avec le PCB, un détecteur connecté au treillis peut également détecter un circuit ouvert sur le treillis. Cette attaque par démontage est par conséquence détectée. Même si un attaquant relie deux point de soudure du treillis sur le PCB lors du démontage du composant flip chip BGA, le détecteur peut toujours détecter cette attaque car la valeur de résistance ne serait pas la même que celle de la résistance R.

La figure 5 est une vue de coupe d'un circuit PCB équipé d'un composant flip chip BGA (cache via flip chip) qui protège contre l'accès aux signaux sensibles par les vias. Le cache via flip chip (CvFC) est soudé au-dessous (ou au-dessus) d'une via (convoyant le signal à protéger) du PCB. Dans cet exemple, le treillis 103 qui transmet un signal de protection traverse le cache via flip chip (CVFC), par l'intermédiaire des billes de soudure 341 et 343 et les points de soudure 321 et 322, et la résistance R. La masse peut être une piste de cuivre sur la couche de PCB, à laquelle le cache via flip chip est soudé. Cette piste de masse et connectée, par soudage, aux billes périphériques de la matrice de billes 340.

Bien entendu, il ne s'agit là que d'une présentation d'une configuration particulière. Il est par exemple envisageable d'utiliser une puce d'disposant d'un nombre plus important de connexions. On peut par exemple utiliser une puce comprenant soixante-quatre connexions à la place de seize connexions. Un mode de réalisation avec soixante-quatre connexions est présenté en relation avec la figure 6. Dans cet exemple de la figure 6, le principe général de la technique décrite est conservé. A la place d'un seul anneau de masse, comme présenté précédemment, on créé deux anneaux de masse (A1 et A2). Ce mode de réalisation présente deux avantages : la sécurité de l'ensemble est augmentée et la solidité de fixation du composant sur le PCB est améliorée. Par ailleurs, il est également possible de faire transiter le signal du treillis par l'anneau intermédiaire (Al).

D'autres configurations ou modes de réalisation peuvent également être mis en oeuvre sans sortir du cadre de l'invention.

## Revendications

1. Composant électronique (300) comprenant :
- une enveloppe (310) formant boîtier ;
- une plaque de circuit imprimé (320) ;
- une pluralité de billes intégrées au sein d'une matrice de bille (BGA) ;
ledit composant étant **caractérisé en ce que** ladite plaque de circuit imprimé (320) comprend au moins un circuit définissant au moins un anneau de garde (Ag, A1, A2).

2. Composant électronique selon la revendication 1, **caractérisé en ce que** ladite plaque de circuit imprimé (320) comprend en outre au moins un circuit de liaison (CL) entre une première connexion (321) et une deuxième connexion (323) de ladite plaque de circuit imprimé.

3. Composant électronique selon la revendication 2, **caractérisé en ce qu'**un circuit de liaison comprend au moins une résistance d'une valeur prédéterminée.

4. Procédé de protection d'un signal électrique transitant par l'intermédiaire d'une via d'un circuit imprimé multicouches, ladite via reliant au moins deux couches dudit circuit imprimé multicouches, procédé **caractérisé en ce qu'**il met en oeuvre un composant électronique (300, CVFC) selon la revendication 1.

5. Utilisation d'un composant électronique selon l'une quelconque des revendications 1 à 3 pour protéger un signal transitant entre au moins deux couches d'un circuit imprimé d'un dispositif électronique.

6. Dispositif électronique de saisie de données **caractérisé en ce qu'**il comprend un composant électronique selon l'une quelconque des revendications 1 à 3 fixé sur un circuit imprimé pour protéger un signal transitant entre au moins deux couches dudit circuit imprimé.
